(19) Europäisches Patentamt
European Patent Office
Office européen des brevets

(11) **EP 1 816 750 A1**

(12) **EUROPEAN PATENT APPLICATION**

(43) Date of publication:
**08.08.2007 Bulletin 2007/32**

(51) Int Cl.:
**H03M 13/11** *(2006.01)*

(21) Application number: **06002168.0**

(22) Date of filing: **02.02.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU**<br><br>(71) Applicant: **SIEMENS AKTIENGESELLSCHAFT**<br>**80333 München (DE)** | (72) Inventors:<br>• **Costa, Elena, Dr.**<br>  **81739 München (DE)**<br>• **Schulz, Egon, Dr.**<br>  **80993 München (DE)**<br>• **Trifonov, Peter**<br>  **195256 St.Petersberg (RU)** |

(54) **Encoding and decoding of extended irregular repeat-accumulate (eIRA) codes**

(57)     A novel construction of irregular LDPC codes based on block-permutation matrices is presented. It generalizes the existing constructions by introducing an additional row permutation of the parity check matrix. An optimization algorithm is presented for computing the permutation parameters.

Fig. 4

## Description

The invention concerns a method for encoding a data message K for transmission from a sending station to a receiving station as well as a respective method for decoding, a respective sending station, a respective receiving station and respective software.

Construction of good low-density parity-check codes (LDPC codes) became recently one of the hottest research topics in coding theory. In spite of substantial progress in the asymptotical analysis of LDPC codes [1], constructing practical codes of short and moderate length still remains an open problem. The main reason for this is that density evolution analysis requires one to construct irregular LDPC codes, while most of the algebraic code design techniques developed up to now can produce only regular constructions, which inherently lack the capacity approaching behavior. Furthermore, the performance of practical length LDPC codes depends not only on the asymptotic iterative decoding threshold, but also on code minimum distance.

For high-rate codes, minimum distance appears to be the dominant factor. This allows one to solve the code construction problem using traditional techniques of coding theory, like finite geometries, difference sets, etc (see for example [2, 3, 4]) . But for lower rate codes (e.g. rate 1/2) one has to find a trade-off between the minimum distance and iterative decoding threshold. This is typically achieved by performing some kind of conditioned random search [5,6,7]. Codes obtained with these methods exhibit very good performance, but are very difficult to implement due to absence of any structure. One way to solve this problem is to modify a structured regular parity check matrix so that it becomes irregular [8,9]. However, there is no formalized way to perform such modification, and many trials have to be performed before good code is found.

LDPC codes represent a sub-class of linear codes. Any codeword c of a linear code satisfies the equation $Hc^T=0$, where H is a parity check matrix of the code. On the other hand, for a given data message K the corresponding codeword can be obtained as c=KG, where G is a generator matrix of the code. This implies that the parity check matrix H and the generator matrix G must satisfy the equation $HG^T=0$. For a given parity check matrix H, it is possible to construct many different generator matrices G. It is always possible (probably after applying a column permutation to the check matrix H) to construct a generator matrix in the form G=[A I], where I is the identity matrix, and A is some other matrix. In this case the codeword corresponding to a data message K looks like c=KG=[KA K], i.e. the data message K appears as a sub vector of the codeword. This is known as systematic encoding. The advantage of systematic encoding is that as soon as all channel errors are removed from the codeword, the data message can be immediately extracted from it, without any post-processing. In some cases it is possible to construct other methods for systematic encoding of data messages, more efficient than multiplication by the generator matrix in systematic form. However, the encoding method does not affect the error correction capability of the code.

It is also true that if H is a parity check matrix of some linear code, then product SH is also a parity check matrix for the same code, where S is a non-singular matrix. In particular, if S is a permutation matrix, and H is a low-density matrix, running the belief propagation LDPC decoding algorithm [10] over SH matrix would give exactly the same results as for the case of the original H matrix.

An object of the present invention is to provide an improved method for encoding a data message in such a way to allow recovery from errors caused by transmission over a noisy channel. It is a further object of the invention to provide a respective sending station and a respective receiving station as well as respective software.

The object is achieved by a method for encoding, a method for decoding, a sending station, a receiving station and software according to independent claims.

Advantageous embodiments are subject matter of dependent claims.

According to the inventive method for encoding a data message K for transmission from a sending station to a receiving station, the encoding generates a codeword c, whereas generating the codeword c is achieved by and/or mathematically writable as multiplication of the data message K with a generator matrix G, c=KG, whereas the generator matrix G is a solution of a matrix equation $HG^T=0$, with H being a parity check matrix and $H=[H_z \ H_i]$, where $H_z$ is a matrix with two adjacent diagonals of 1's having 0 in all other positions, and $H_i$ is a matrix obtained by interleaving rows of a first matrix $H_u$, which is a block matrix consisting of permutation matrices and zero matrices.

This means that the parity check matrix H of the code is given by $H=[H_z \ SH_u]=S[S^{-1}H_z \ H_u]$, where S is a permutation matrix used for interleaving rows of the first matrix $H_u$. Since permuting rows of the parity check matrix does not change the code, one can use also a parity check matrix in the form $[S^{-1}H_z \ H_u]$.

In addition to interleaving rows, it is also possible to interleave the columns of matrix H. The resulting code is equivalent and has the same performance as the code generated without interleaving columns.

In one embodiment a generator matrix G is used, which satisfies the condition $G=[(H_z^{-1}H_i)^T \ I]$.

Therefore, if the codeword c is mathematically written as $c = [c_z \ c_i]$, the multiplication of the data message K and this generator matrix G results in $c_i$ being the data message K, while $c_z$ is given by $c_z^T= H_z^{-1}H_iK^T$. Multiplication by the sub matrix $H_z^{-1}H_i$ can be implemented either straightforwardly, or as a sequence of the following transformations. Since $H_i=SH_u$, where S is the permutation matrix used for interleaving rows of the first matrix $H_u$, one can either multiply the vector $K^T$ (the data message) directly by $H_i$, or multiply it first by $H_u$, and then interleave elements of the obtained vector. Multiplication of a vector by matrix $H_z^{-1}$ may be implemented by means of a filter with the transfer function $1/(1+D)$.

Advantageously a rectangular interleaver is used for interleaving rows of the first matrix $H_u$.

Advantageously the first matrix $H_u$ is generated by expansion of a template matrix P of dimension s $\times$ t, the expansion being made by replacing all elements $p_{ij}$ of the template matrix P which satisfy the condition $0 \leq p_{ij} < \infty$ with cyclic permutation matrices of dimension p $\times$ p, having a value 1 at positions (r, $(p_{ij} + r)$ mod p), with r=0 ..p-1, i=0 .. s-1 and j=0..t-1, and replacing all other element of P which satisfy the condition $p_{ij} = \infty$ or $p_{ij} < 0$ with p $\times$ p zero matrices.

The inventive method for decoding a data message K from a codeword c received from a sending station shows all necessary steps to decode the codeword c and uses a parity check matrix H which is build according to the inventive method for encoding. According to the inventive method for encoding, the parity check matrix H is used in an equation $HG^T=0$ which has to be satisfied by a generator matrix G that is usable for mathematically expressing encoding of the data message K.

An inventive method for decoding is e.g. performed by using a parity check matrix H used for encoding according to the inventive method for encoding in step 5 of a decoder described on page 15 in [10].

The inventive sending station comprises an encoding unit to encode a data message K into a codeword c, whereas generating the codeword c is achieved by and/or mathematically writable as multiplication of the data message K with a generator matrix G, c=KG, whereas the generator matrix G is a solution of a matrix equation $HG^T=0$, with H= [$H_z$ $H_i$] where $H_z$ is a matrix with two adjacent diagonals of 1's having 0 in all other positions, and $H_i$ is a matrix obtained by interleaving rows of a first matrix $H_u$, which is a block matrix consisting of permutation matrices and zero matrices.

The inventive receiving station comprises decoding means for decoding a codeword c received from a sending station using a parity check matrix H build according to the inventive method for encoding for checking parity of codeword c.

The inventive software for encoding a data message K comprises program code which outputs a codeword c from an input data message K, if the software is running on a computer, by use of the inventive method for encoding.

Further, the inventive software for decoding a codeword c comprises program code which outputs a data message K from an input codeword c and uses a parity check matrix H build according to the inventive method for encoding, if the software is running on a computer.

In the following the invention is described according to embodiments shown in figures:

Fig. 1    Tanner graph of an example code (state of the art),

Fig. 2    parity check matrix and Tanner graph with a zigzag pattern

Fig. 3    first embodiment of an inventive encoder,

Fig. 4    second embodiment of an inventive encoder,

Fig. 5    template matrix P for rate 1/2 codes,

Fig. 6    performance of rate 1/2 codes

Fig. 7    performance of rate 2/3 codes

Fig. 8    template matrix P for rate 2/3 codes

A sending station is for example a terminal or a base station of a radio communications system.

A receiving station is for example a terminal or a base station of a radio communications system.

A terminal is for instance a mobile radio terminal, particularly a mobile phone or a flexible of fixed device, for transmission of picture data and/or sound data, for fax, short message service (SMS) messages and/or E-mail messages, and/or for internet access.

The invention can advantageously be used in any kind of communications system. A communications system is for example a computer network or a radio communications system.

Radio communications systems are systems in which a data transmission between terminals is performed over an air interface. The data transmission can be both bidirectional and unidirectional. Radio communications systems are particularly cellular radio communication systems, e.g. according to the GSM (Global System for Mobile Communications) standard or the UMTS (Universal Mobile Telecommunication System) standard. Also future mobile radio communications systems, e.g. according to the fourth generation, as well as ad-hoc-networks shall be understood as radio communication systems. Radio communication systems are also wireless local area networks (WLAN) according to standards from the Institute of Electrical and Electronics Engineers (IEEE) like 802.11a-i, HiperLAN1 and HiperLAN2 (High Performance Radio Local Area Network) as well as Bluetooth-Networks.

**An overview of LDPC codes**

LDPC codes are defined as a class of linear binary codes having a sparse $m \times n$ parity check matrix $H$. The dimension of the code is given by $k \geq n-m$. Alternatively, the LDPC code can be characterized by a bi-partite graph (Tanner graph) with $n$ variable nodes and $m$ check nodes [10]. An edge connects variable node $j$ with check node $i$ if and only if $H_{ij}=1$. For example, consider the following parity check matrix:

$$H = \begin{pmatrix} 1 & 1 & 1 & 1 & 0 & 0 & 0 & 0 & 0 & 0 \\ 1 & 0 & 0 & 0 & 1 & 1 & 1 & 0 & 0 & 0 \\ 0 & 1 & 0 & 0 & 1 & 0 & 0 & 1 & 1 & 0 \\ 0 & 0 & 1 & 0 & 0 & 1 & 0 & 1 & 0 & 1 \\ 0 & 0 & 0 & 1 & 0 & 0 & 1 & 0 & 1 & 1 \end{pmatrix}.$$

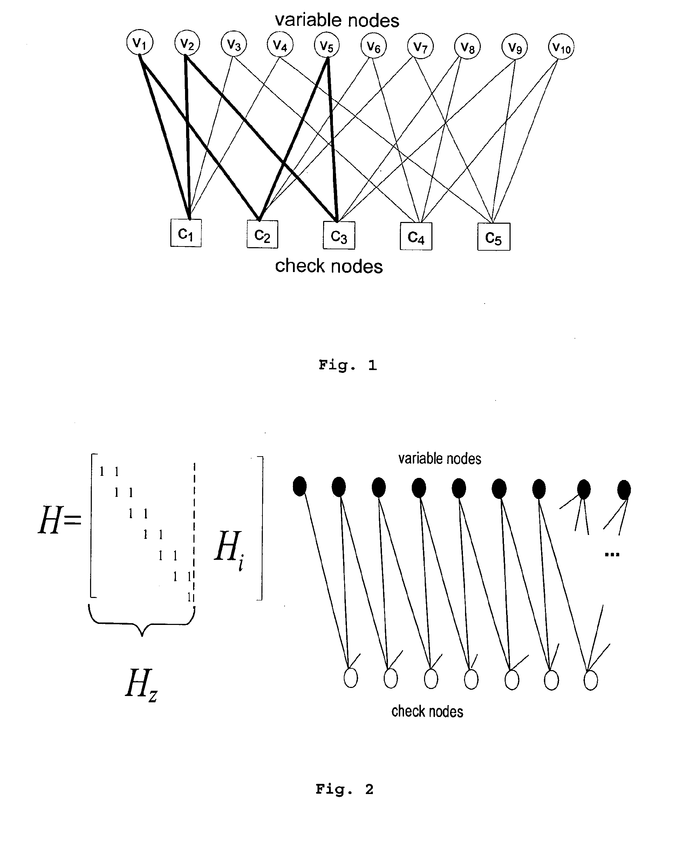

Figure 1 presents the associated Tanner graph.
The degree of a node in the graph is the number of edges connected to this node. If different nodes in the Tanner graph have different degree, the code is called irregular. Otherwise, the code is said to be regular. The Tanner graph is characterized by its variable and check node degree distributions $\lambda(x)=\Sigma_i\lambda_ix^{i-1}$ and $\rho(x)=\Sigma_i \rho_ix^{i-1}$, where $\lambda_i$ and $\rho_i$ are the fractions of edges connected to degree-$i$ variable and check nodes, respectively. These edge perspective distributions can be translated into the node perspective distributions $\Lambda(x) = \Sigma_i\Lambda_ix^{i-1}$ and $R(x)=\Sigma_i R_ix^{i-1}$, where $\Lambda_i$ and $R_i$ are the fractions of variable and check *nodes* of degree $i$. Graph-based description of LDPC code allows one to design an iterative message-passing decoding algorithm [10]. This algorithm was analyzed in [11] for the case of infinitely long codes and binary-input memoryless output-symmetric channels. It was shown that for a given ensemble of LDPC codes there exists a value of the channel parameter (e.g. signal-to-noise ratio), so that the iterative decoding is successful for all parameter values greater than this threshold. It is possible to design a numeric algorithm for computing the threshold for given node degree distributions, and even perform their optimization in order to minimize it [11].
For finite-length LDPC codes, the performance depends not only on the asymptotic iterative decoding threshold, but also on the loop structure of the code. The girth of a Tanner graph is the minimum cycle length of the graph. The girth of the graph on Figure 1 is 6, since there is a length-6 loop $v_1$-$c_1$-$v_2$-$c_3$-$v_5$-$c_2$-$v_1$ connecting its vertices. Short (especially, length 4) cycles are known to have negative impact on the performance of the message-passing decoding algorithm, so such Tanner graphs should be, in general, avoided. However, in [6] it was shown that not all short loops are equally harmful. If the nodes in a loop are connected to the nodes not participating in this loop, the extrinsic information can still flow over the Tanner graph, and the decoding can proceed. It is possible to introduce the *approximate cycle extrinsic message degree (ACE)* of a loop as [6]

$$ACE = \sum_i (d_i - 2), \qquad\qquad (1)$$

where summation is performed over all variable nodes in the loop, and $d_i$ is the degree of the $i$-th variable node. One can impose a constraint $ACE_{min}>\eta$ on minimum ACE value over all loops of length $l \leq 2l_{ACE}$ in a Tanner graph being constructed. In [12] it was shown that in this case the number of stopping sets (i.e. erasure configurations unrecoverable by the message-passing algorithm) of size $\leq l_{ACE}$ decreases exponentially with $\eta$. Since positions of non-zero symbols of any codeword also constitute a stopping set, ACE conditioning improves also code minimum distance (and, in general, weight spectrum).
Equation (1) implies that ACE of a loop involving only degree-2 nodes is equal to zero. Furthermore, it is known that any loop of length $2l$ in a degree-2 part of the Tanner graph corresponds to a weight-$l$ codeword. Since optimized node degree distributions usually have $1>\Lambda_2>> 0$ (i.e. there should be substantial amount of degree-2 nodes), it is especially important to maximize the length of loops passing through the degree-2 part of the Tanner graph. This can be achieved by arranging as many as possible degree-2 nodes into the zigzag pattern shown on Figure 2. If needed, the remaining degree-2 nodes may be packed into the part $H_i$. Zigzag pattern does also not need to involve all check nodes. This implies that the zigzag pattern is a very good starting point in the design of a LDPC code.

Observe, that systematic encoding of a data message K with such a code can be performed by multiplying K with a generator matrix G = [($H_z^{-1}H_i$)$^T$ I]

### Description of embodiments

The inventors have recognised that the matrix $H_i$ should be constructed under the following constraints:

1. the Tanner graph of the obtained parity check matrix $H = [H_z\ H_i]$ should have the node degree distribution approximately equal to the target one;
2. low-weight codewords should be avoided;
3. more generally, small stopping sets in $H$ should be avoided, i.e. the constraint $ACE \leq \eta$ for some $\eta$ should be satisfied;
4. length-4 loops should be avoided;
5. $H_i$ should be structured.

These guidelines are implemented in an algorithm for constructing $H_i$.

We propose to construct $H_i$ in two steps. First, let us expand a $s \times t$ template matrix $P$, i.e. replace its elements $p_{ij}$: $0 \leq p_{ij} < \infty$ with $p \times p$ cyclic permutation matrices having 1's in positions $(r,(p_{ij}+r) \bmod p), r=0..p-1, i=0..s-1, j=0..t-1$. All other elements of P are replaced with $p \times p$ zero matrices. A first matrix $H_u$ is obtained by expanding the template matrix P. Second, let us permute (interleave) the rows of the first matrix $H_u$. This leads to a $sp \times tp$ matrix $H_i$. One possible row permutation is given by a rectangular interleaver: $\Pi(i) = (i \bmod p)s + \left\lfloor \frac{i}{p} \right\rfloor, i = 0..sp-1$. Here $s$, $p$ and $t$ are the parameters of the construction. Appending z zigzag columns to $H_i$, one obtains the $m \times n$ parity check matrix $H$ with $m=sp$, $n=tp+z$. The template matrix P is the result of an optimization process described below, using a prototype matrix M, having 1's in positions (i, j) : $0 \leq p_{ij} < \infty$, and 0 elsewhere.

Observe that $H_i$ can be specified with at most $\overline{M}$ integers $p_{ij}$, where $\overline{M}$ is the number of 1's in the prototype matrix $M$.

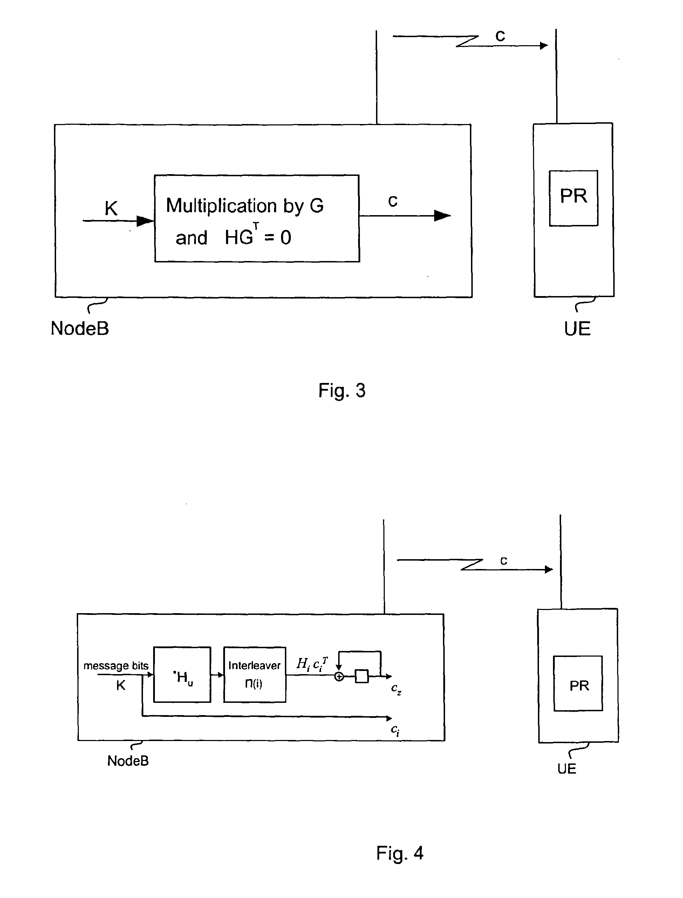

Figure 3 and figure 4 illustrate embodiments of an inventive encoder for the described code, used for encoding a data message K into a codeword c. The data message K is e.g. a vector of $k$ Bits which has to be transmitted from a sending station NodeB to a receiving station UE. The receiving station UE has a processor PR to decode the codeword c, whereas decoding comprises using the parity check matrix H to run the belief propagation decoding algorithm and parity check the codeword c.

In Figure 3 the codeword c, which can mathematically be written as c = [$c_z$ $c_i$], is generated by multiplying the data message K by a generator matrix G, which must satisfy the equation HG$^T$=0. The parity check matrix $H=[H_zH_i]$ is build as described in the very last paragraph.

In Figure 4 an even more efficient approach is presented by using a generator matrix G which satisfies the condition G=[($H_z^{-1}H_i$)$^T$ I]. Therefore, if the codeword c is mathematically written as c = [$c_z$ $c_i$], the multiplication of the data message K and this generator matrix G results in the first component $c_i$ being the data message K, while the second component $c_z$ is given by $c_z^T=H_z^{-1}H_iK^T$ . I.e. the second component $c_z$ of the codeword c is calculated using row permutation by multiplying the data message K with the first matrix $H_u$ and by permuting the rows of the result of this multiplication and by filtering the result. Alternatively, the row permutation can by applied to the first matrix $H_u$ before multiplication with the data message K. The parity check matrix H, i.e. the matrices $H_i$ and $H_z$ are build in the same way as described for figure 3.

The prototype matrix $M$ can be constructed by different methods, e.g. manually, or using the PEG algorithm [5], so that it satisfies approximately the given node degree distribution pair $(\Lambda(x),R(x))$. Particular values of $p_{ij}$ integers in the template matrix P should be selected so that the obtained parity check matrix $H$ satisfies the requirements 1-5 presented above. The following section presents a randomized algorithm for computing them.

### Optimization algorithm

The idea of the optimization algorithm presented below is that low-weight input words after multiplication by the first matrix $H_u$, the interleaver, and $1/(1+D)$ filter as shown in figure 4, should not transform into low-weight vectors $(c_z,c_i)$. This is very similar to the problem of constructing inter-leavers for turbo codes.

The structure of the zigzag pattern allows one to calculate the weight of the $y = H_z^{-1} x$ vector as

$$S(x) = \begin{cases} \sum_{j=0}^{\lceil l/2 \rceil - 1} (x_{l-2j} - x_{l-2j-1}), \text{if } x_l < z \\ \infty, \text{otherwise} \end{cases} \tag{1}$$

where $z$ is the number of variable nodes in the zigzag pattern, $x_j: 1 \leq x_j < x_{j+1} < ... \leq m, j = 1..l$ are positions of non-zero bits in the vector $x$ at the input of the zigzag encoder, and $x_0 = 0$. This expression takes into account the case of zigzag pattern not covering all check nodes in the graph, and the case of linearly dependent columns in $H_i$.

In principle, this allows one to consider all possible input patterns, compute for a given $p_{ij}$ set the input vector $x = H_i c_i^T$ of the 1/(1+D) filter, find the weight of the filter output, and deduce the minimum distance $d_{min}$ of the code obtained. Then one can perform maximization of $d_{min}$ over all possible $p_{ij}$ values. However, this approach is quite impractical due to exponential number of input patterns, and huge size of the search space. Therefore one has to limit the search scope to data messages $K$ of $k$ Bits having sufficiently small weight wt($K$)$\leq w$. Furthermore, the optimization of $p_{ij}$ values can be performed on the column-by-column basis using a variation of a genetic algorithm:

1. Construct a prototype matrix M with the required column and row degree distribution.
2. Let $j := 0$.
3. Generate $p_{ij}$ randomly for all $i$ s.t. $M_{ij} = 1$.
4. Make sure that the matrix $\hat{H}_i$ obtained by expanding first $j + 1$ columns of the template matrix $P$ and by permuting rows of the expanded matrix appropriately, does not have length-4 loops and its minimal ACE is not less than a given threshold $\eta$. This can be implemented efficiently using the algorithms presented in [13,6]. Go to step 3 in case of failure.
5. Consider all possible input patterns $K \in GF(2)^{(j+1)p} : $ wt($K$) $\leq w$. Determine the weights of the associated output vectors of the zigzag encoder using (1), and find the minimal codeword weight, which is denoted here by $S_{min}$.
6. Repeat steps 3-5 a given number of times, and select $p_{ij}$ values maximizing $S_{min}$. Let $\hat{d}_j$ be the maximal value of $S_{min}$.
7. Let $j := j+1$.
8. if $j < t$, go to step 1.

Observe that $\hat{d} = \min_j \hat{d}_j$ gives an upper bound on the minimum distance of the code obtained. Clearly, increasing $w$, the weight of input vectors being analyzed, improves the accuracy of this estimate. In practice, for well-chosen prototype matrices $M$, it is sufficient to set $w \approx 5$ to obtain $\hat{d}$ very close to the true minimum distance of the code.

The algorithm presented above optimizes the template matrix P for a fixed value of the expansion factor p. However, it is possible to consider simultaneously a number of different expansion factors, maximizing at step 6 the weighted sum of estimated minimum distances of the codes obtained for the same template matrix P, but different expansion factors p. As a consequence, a unique template matrix P for parity check matrices for a number of different code lengths, but the same rate, is obtained.

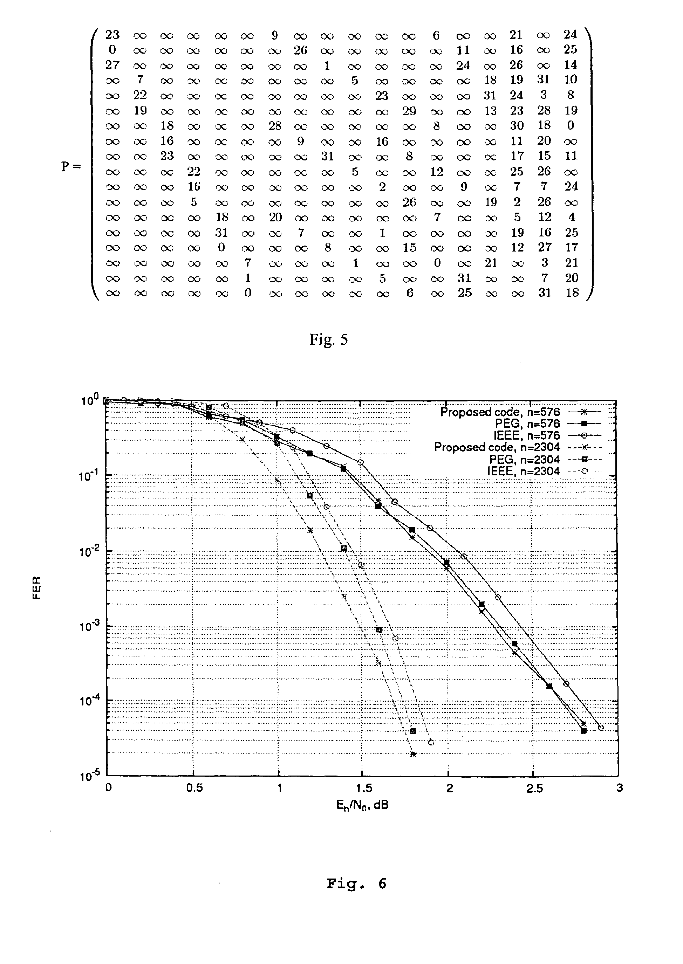

The proposed algorithm generalizes the methods presented in [8,9,14] in several ways. First, interleaving of rows of the first matrix $H_u$ can be considered as an additional degree of freedom in optimization of the LDPC code. The optimization algorithm presented above does not depend on it explicitly. Second, there are no artificial restrictions on $p_{ij}$ values coming from the original algebraic LDPC constructions (cf. [8,15]). The price for this is absence of an explicit algorithm for computing $p_{ij}$. But since the number of these values is quite small compared to the size of the template matrix P (see Figures 5 and 8), this is not a serious drawback. Third, the process of finding good codes is formalized, and the number of trial-and-error attempts is reduced. Provided that sufficient computational power is available, the proposed algorithm can produce reliable estimates of the minimum distance of the code obtained, providing thus valuable feedback to the code designer.

**Numeric results**

The template matrix P in Figure 5 can be used for construction of rate 1/2 codes to be used e.g. in the embodiments according to figure 3 or 4. Each integer entry $p_{ij}$ should be replaced with a $p \times p$ cyclic permutation matrix given by $p_{ij}$, while $\infty$ entries should be replaced with $p \times p$ zero matrices. z=ps zigzag columns should be added to it after expanding it and permuting the rows.

The row permutation used is (rectangular interleaver) $\Pi(i) = (i \bmod p)s + \left\lfloor \frac{i}{p} \right\rfloor, i$ = 0..sp-1. Figure 6 presents simulation results illustrating the performance of the obtained codes in AWGN channel, as well as the performance of PEG and IEEE 802.16 [16] codes with similar parameters.

It can be seen that the proposed code outperforms IEEE codes, and in some cases even fully random PEG codes, which are currently considered to be the best ones from the point of view of performance.

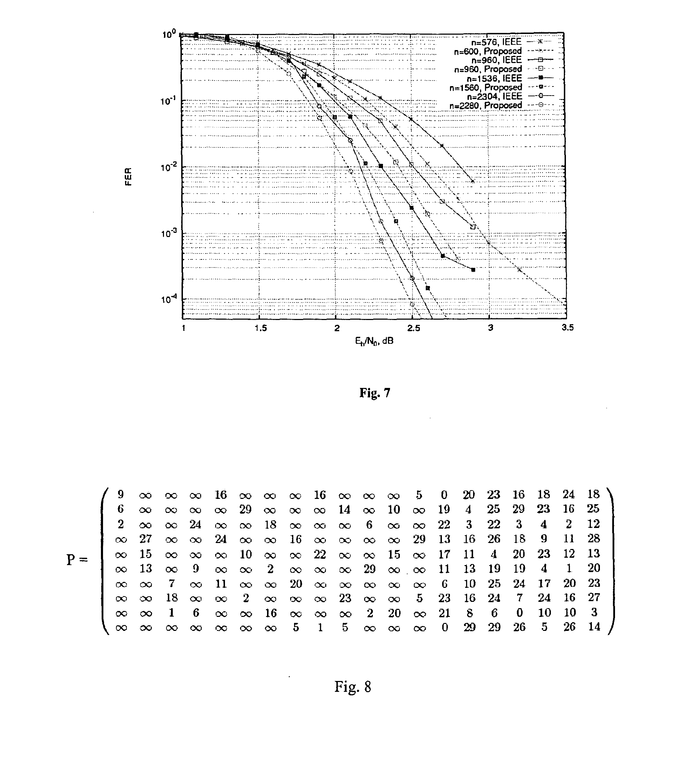

Figure 7 illustrates the performance of rate 2/3 codes, and Figure 8 presents a compact representation of the corresponding template matrix P. The row permutation used is (rectangular interleaver) $\Pi(i) = (i \bmod p)s + \left\lfloor \frac{i}{p} \right\rfloor, i$

= 0..sp-1. It can be seen that the proposed code considerably outperforms the IEEE one.

A method for constructing structured irregular LDPC codes was presented. The code construction is based on a block-permutation matrix with additional row permutation. The parameters of the permutation matrix are filled by an optimization algorithm, which attempts to maximize the code minimum distance. The numeric results indicate that the codes obtained with this method have excellent minimum distance and no visible error floor.

The proposed construction allows many generalizations and improvements. For example, it is possible to replace the cyclic permutation matrices with some other parametric permutations, e.g. based on permutation polynomials. Second, additional LDPC performance criteria can be integrated into the optimization algorithm.

References

[1] T. Richardson, M. A. Shokrollahi, and R. L. Urbanke, "Design of capacity-approaching irregular low-density parity-check codes," IEEE Transactions On Information Theory, vol. 47, no. 2, pp. 619-637, February 2001.

[2] Y. Kou, S. Lin, and M. P. C. Fossorier, "Low-density parity-check codes on finite geometries: A rediscovery and new results," IEEE Transactions on Information Theory, vol. 47, no. 7, November 2001.

[3] B. Ammar, B. Honary, Y. Kou, J. Xu, and S. Lin, "Construction of low-density parity-check codes based on balanced incomplete block designs," IEEE Transactions on Information Theory, vol. 50, no. 6, June 2004.

[4] S. J. Johnson and S. R. Weller, "Resolvable 2-designs for regular low-density parity-check codes," IEEE Transactions on Communications, vol. 51, no. 9, September 2003.

[5] X.-Y. Hu, E. Eleftheriou, and D.-M. Arnold, "Regular and irregular progressive edge-growth Tanner graphs," IEEE Transactions on Information Theory, vol. 51, no. 1, January 2005.

[6] T. Tian, C. Jones, J.D. Villasenor, and R.D. Wesel, "Selective avoidance of cycles in irregular LDPC code construction," IEEE Transactions On Communications, vol. 52, no. 8, August 2004.

[7] Hua Xiao and Amir H. Banihashemi, "Improved progressive-edge-growth (PEG) construction of irregular LDPC codes," IEEE Communications Letters, vol. 8, no. 12, pp. 715-717, December 2004.

[8] Dale E. Hocevar, "LDPC code construction with flexible hardware implementation," in Proceedings of IEEE International Conference on Communications, May 2003, pp. 2708-2711.

[9] Jingyu Kang, Pingyi Fan, and Zhigang Cao, "Flexible construction of irregular partitioned permutation LDPC codes with low error floors," IEEE Communications Letters, vol. 9, no. 6, June 2005.

[10] W. E. Ryan, "An introduction to LDPC codes," in CRC Handbook for Coding and Signal Processing for Recording Systems, B. Vasic, Ed. CRC Press, 2004.

[11] S.-Y. Chung, G. D. Forney, T. J. Richardson, and R. Urbanke, "On the design of low-density parity-check codes within 0.0045 dB of the Shannon limit," IEEE Communications Letters, vol. 5, no. 2, February 2001.

[12] A. Ramamoorthy and R. Wesel, "Analysis of an algorithm for irregular LDPC code construction," in Proceedings of IEEE International Symposium on Information Theory, 2004, p. 69.

[13] Marc P.C. Fossorier, "Quasi-cyclic low-density parity check codes from circulant permutation matrices," IEEE Transactions On Information Theory, vol. 50, no. 8, August 2004.

[14] Rich Echard and Shih-Chun Chang, "Design considerations leading to the development of good π-rotation LDPC codes," IEEE Communications Letters, vol. 9, no. 5, May 2005.

[15] R.M. Tanner, Deepak Sridhara, Arvind Sridharan, Thomas E. Fuja, and Daniel J. Costello, "LDPC block and convolutional codes based on circulant matrices," IEEE Transactions on Information Theory, vol. 50, no. 12, December 2004.

[16] B. Classon and Y. Blankenship et al, "LDPC coding for OFDMA PHY," Tech. Rep. C802.16e-05/066r3, IEEE 802.16 Broadband Wireless Access Working Group, 2005.

**Claims**

1. Method for encoding a data message K for transmission from a sending station to a receiving station, whereas the encoding generates a codeword c, whereas generating the codeword c is achieved by and/or mathematically writable as multiplication of the data message K with a generator matrix G, c=KG, whereas the generator matrix G is a solution of a matrix equation $HG^T=0$, with H=[$H_z$ $H_i$], where $H_z$ is a matrix with two adjacent diagonals of 1's having 0 in all other positions,

   **characterised in that**,

   $H_i$ is a matrix obtained by interleaving rows of a first matrix $H_u$, which is a block matrix consisting of permutation matrices and zero matrices.

2. The method according to claim 1, further comprising using the generator matrix G given by G=[$(H_z^{-1}H_i)^T$ I].

3. The method according to claim 1 or 2, further comprising using a rectangular interleaver for interleaving rows of the first matrix $H_u$.

4. The method according to claim 1, 2 or 3, further comprising
   the first matrix $H_u$ being generated by expansion of a template matrix P of dimension s $\times$ t, the expansion being made by replacing all elements $p_{ij}$ of the template matrix P which satisfy the condition $0 \leq p_{ij} < \infty$ with cyclic permutation matrices of dimension p $\times$ p, having a value 1 at positions (r, ($p_{ij}$ + r) mod p), with r=0..p-1, i=0..s-1 and j=0..t-1, and replacing all other elements $p_{ij}$ which satisfy the condition $p_{ij} = \infty$ or $p_{ij} < 0$ with p $\times$ p zero matrices, where $p_{ij}$ are some integers.

5. Sending station, comprising
   an encoding unit to encode a data message K into a codeword c, whereas generating the codeword c is achieved by and/or mathematically writable as multiplication of the data message K with a generator matrix G, c=KG, whereas the generator matrix G is a solution of a matrix equation $HG^T=0$, with H=[$H_z$ $H_i$], where $H_z$ is a matrix with two adjacent diagonals of 1's having 0 in all other positions,
   **characterised in that**,
   $H_i$ is a matrix obtained by interleaving rows of a first matrix $H_u$, which is a block matrix consisting of permutation matrices and zero matrices.

6. Method for decoding a data message K from a codeword c received from a sending station, using a parity check matrix H build according to claim 1.

7. Receiving station, comprising
   decoding means for decoding a codeword c received from a sending station, using a parity check matrix H build according to claim 1 for checking parity of codeword c.

8. Software for encoding a data message K, comprising program code which outputs a codeword c from an input data message K, if the software is running on a computer, by use of the method according to one of claims 1 to 4.

9. Software for decoding a codeword c, comprising program code which outputs a data message K from an input codeword c and uses a parity check matrix H build according to claim 1, if the software is running on a computer.

variable nodes

check nodes

Fig. 1

$$H = \begin{bmatrix} \begin{matrix} 1 & 1 & & & & & \\ & 1 & 1 & & & & \\ & & 1 & 1 & & & \\ & & & 1 & 1 & & \\ & & & & 1 & 1 & \\ & & & & & 1 & 1 \\ & & & & & & 1 \end{matrix} & \vdots & H_i \end{bmatrix}$$

$\underbrace{\qquad}_{H_z}$

variable nodes

check nodes

Fig. 2

**Fig. 3**

**Fig. 4**

$$P = \begin{pmatrix}
23 & \infty & \infty & \infty & \infty & \infty & 9 & \infty & \infty & \infty & \infty & \infty & 6 & \infty & \infty & 21 & \infty & 24 \\
0 & \infty & \infty & \infty & \infty & \infty & \infty & 26 & \infty & \infty & \infty & \infty & \infty & 11 & \infty & 16 & \infty & 25 \\
27 & \infty & \infty & \infty & \infty & \infty & \infty & \infty & 1 & \infty & \infty & \infty & \infty & 24 & \infty & 26 & \infty & 14 \\
\infty & 7 & \infty & \infty & \infty & \infty & \infty & \infty & \infty & 5 & \infty & \infty & \infty & \infty & 18 & 19 & 31 & 10 \\
\infty & 22 & \infty & \infty & \infty & \infty & \infty & \infty & \infty & \infty & 23 & \infty & \infty & \infty & 31 & 24 & 3 & 8 \\
\infty & 19 & \infty & \infty & \infty & \infty & \infty & \infty & \infty & \infty & \infty & 29 & \infty & \infty & 13 & 23 & 28 & 19 \\
\infty & \infty & 18 & \infty & \infty & \infty & 28 & \infty & \infty & \infty & \infty & \infty & 8 & \infty & \infty & 30 & 18 & 0 \\
\infty & \infty & 16 & \infty & \infty & \infty & \infty & 9 & \infty & \infty & 16 & \infty & \infty & \infty & \infty & 11 & 20 & \infty \\
\infty & \infty & 23 & \infty & \infty & \infty & \infty & \infty & 31 & \infty & \infty & 8 & \infty & \infty & \infty & 17 & 15 & 11 \\
\infty & \infty & \infty & 22 & \infty & \infty & \infty & \infty & \infty & 5 & \infty & \infty & 12 & \infty & \infty & 25 & 26 & \infty \\
\infty & \infty & \infty & 16 & \infty & \infty & \infty & \infty & \infty & \infty & 2 & \infty & \infty & 9 & \infty & 7 & 7 & 24 \\
\infty & \infty & \infty & 5 & \infty & \infty & \infty & \infty & \infty & \infty & \infty & 26 & \infty & \infty & 19 & 2 & 26 & \infty \\
\infty & \infty & \infty & \infty & 18 & \infty & 20 & \infty & \infty & \infty & \infty & \infty & 7 & \infty & \infty & 5 & 12 & 4 \\
\infty & \infty & \infty & \infty & 31 & \infty & \infty & 7 & \infty & \infty & 1 & \infty & \infty & \infty & \infty & 19 & 16 & 25 \\
\infty & \infty & \infty & \infty & 0 & \infty & \infty & \infty & 8 & \infty & \infty & 15 & \infty & \infty & \infty & 12 & 27 & 17 \\
\infty & \infty & \infty & \infty & \infty & 7 & \infty & \infty & \infty & 1 & \infty & \infty & 0 & \infty & 21 & \infty & 3 & 21 \\
\infty & \infty & \infty & \infty & \infty & 1 & \infty & \infty & \infty & \infty & 5 & \infty & \infty & 31 & \infty & \infty & 7 & 20 \\
\infty & \infty & \infty & \infty & \infty & 0 & \infty & \infty & \infty & \infty & \infty & 6 & \infty & 25 & \infty & \infty & 31 & 18
\end{pmatrix}$$

Fig. 5

Fig. 6

**Fig. 7**

$$P = \begin{pmatrix} 9 & \infty & \infty & \infty & 16 & \infty & \infty & \infty & 16 & \infty & \infty & \infty & 5 & 0 & 20 & 23 & 16 & 18 & 24 & 18 \\ 6 & \infty & \infty & \infty & \infty & 29 & \infty & \infty & \infty & 14 & \infty & 10 & \infty & 19 & 4 & 25 & 29 & 23 & 16 & 25 \\ 2 & \infty & \infty & 24 & \infty & \infty & 18 & \infty & \infty & \infty & 6 & \infty & \infty & 22 & 3 & 22 & 3 & 4 & 2 & 12 \\ \infty & 27 & \infty & \infty & 24 & \infty & \infty & 16 & \infty & \infty & \infty & \infty & 29 & 13 & 16 & 26 & 18 & 9 & 11 & 28 \\ \infty & 15 & \infty & \infty & \infty & 10 & \infty & \infty & 22 & \infty & \infty & 15 & \infty & 17 & 11 & 4 & 20 & 23 & 12 & 13 \\ \infty & 13 & \infty & 9 & \infty & \infty & 2 & \infty & \infty & \infty & 29 & \infty & \infty & 11 & 13 & 19 & 19 & 4 & 1 & 20 \\ \infty & \infty & 7 & \infty & 11 & \infty & \infty & 20 & \infty & \infty & \infty & \infty & \infty & 6 & 10 & 25 & 24 & 17 & 20 & 23 \\ \infty & \infty & 18 & \infty & \infty & 2 & \infty & \infty & \infty & 23 & \infty & \infty & 5 & 23 & 16 & 24 & 7 & 24 & 16 & 27 \\ \infty & \infty & 1 & 6 & \infty & \infty & 16 & \infty & \infty & \infty & 2 & 20 & \infty & 21 & 8 & 6 & 0 & 10 & 10 & 3 \\ \infty & \infty & \infty & \infty & \infty & \infty & \infty & 5 & 1 & 5 & \infty & \infty & \infty & 0 & 29 & 29 & 26 & 5 & 26 & 14 \end{pmatrix}$$

Fig. 8

12

**European Patent Office**

**EUROPEAN SEARCH REPORT**

Application Number

EP 06 00 2168

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YIFEI ZHANG ET AL: "Structured eIRA Codes" PROC., THIRTY-EIGHTH IEEE ASIMOLAR CONFERENCE ON SIGNALS, SYSTEMS AND COMPUTERS, PACIFIC GROVE, CA, USA, 7 November 2004 (2004-11-07), pages 2005-2009, XP010781401 ISBN: 0-7803-8622-1 * page 2005; figure 1 * * page 2007, left-hand column, paragraph 2 - right-hand column, paragraph 2 *<br>----- | 1-9 | INV. H03M13/11 |
| A | ECHARD R ET AL: "Irregular pi-rotation LDPC codes" PROC., IEEE GLOBAL TELECOMMUNICATIONS CONFERENCE, GLOBECOM'02, NEW YORK, NY, vol. 1 OF 3, 17 November 2002 (2002-11-17), pages 1274-1278, XP010636350 ISBN: 0-7803-7632-3 * the whole document *<br>----- | 1-9 | |
| A | YU YI ET AL.: "The semi-algebra low-density parity-check codes" PROC., IEEE INTERNATIONAL CONFERENCE ON COMMUNICATIONS, PARIS, FRANCE, 20 June 2004 (2004-06-20), pages 440-443, XP010710384 ISBN: 0-7803-8533-0 * the whole document *<br>-----<br>-/-- | 1-9 | TECHNICAL FIELDS SEARCHED (IPC)<br><br>H03M |

The present search report has been drawn up for all claims

| Place of search | Date of completion of the search | Examiner |
|---|---|---|
| Munich | 29 June 2006 | Offer, E |

EPO FORM 1503 03.82 (P04C01)

**European Patent Office**

## EUROPEAN SEARCH REPORT

Application Number

EP 06 00 2168

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ECHARD R ET AL: "The pi-rotation low-density parity-check codes" PROC., IEEE GLOBAL TELECOMMUNICATIONS CONFERENCE., GLOBECOM '01, SAN ANTONIO, TX, vol. VOL. 2 OF 6, 25 November 2001 (2001-11-25), pages 980-984, XP001099251 ISBN: 0-7803-7206-9 * the whole document * | 1-9 | |
| A | US 2005/204253 A1 (SUKHOBOK SERGEY ET AL) 15 September 2005 (2005-09-15) * figures 2,5-7 * | 1-9 | |

TECHNICAL FIELDS SEARCHED (IPC)

The present search report has been drawn up for all claims

| Place of search | Date of completion of the search | Examiner |
|---|---|---|
| Munich | 29 June 2006 | Offer, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                       
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 00 2168

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2006

| Patent document cited in search report | Publication date | Patent family member(s) | Publication date |
|---|---|---|---|
| US 2005204253 A1 | 15-09-2005 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. RICHARDSON ; M. A. SHOKROLLAHI ; R. L. URBANKE.** Design of capacity-approaching irregular low-density parity-check codes. *IEEE Transactions On Information Theory,* February 2001, vol. 47 (2), 619-637
- **Y. KOU ; S. LIN ; M. P. C. FOSSORIER.** Low-density parity-check codes on finite geometries: A rediscovery and new results. *IEEE Transactions on Information Theory,* November 2001, vol. 47 (7
- **B. AMMAR ; B. HONARY ; Y. KOU ; J. XU ; S. LIN.** Construction of low-density parity-check codes based on balanced incomplete block designs. *IEEE Transactions on Information Theory,* 06 June 2004, vol. 50
- **S. J. JOHNSON ; S. R. WELLER.** Resolvable 2-designs for regular low-density parity-check codes. *IEEE Transactions on Communications,* September 2003, vol. 51 (9
- **X.-Y. HU ; E. ELEFTHERIOU ; D.-M. ARNOLD.** Regular and irregular progressive edge-growth Tanner graphs. *IEEE Transactions on Information Theory,* January 2005, vol. 51 (1
- **T. TIAN ; C. JONES ; J.D. VILLASENOR ; R.D. WESEL.** Selective avoidance of cycles in irregular LDPC code construction. *IEEE Transactions On Communications,* 08 August 2004, vol. 52
- **HUA XIAO ; AMIR H. BANIHASHEMI.** Improved progressive-edge-growth (PEG) construction of irregular LDPC codes. *IEEE Communications Letters,* December 2004, vol. 8 (12), 715-717
- **DALE E. HOCEVAR.** LDPC code construction with flexible hardware implementation. *Proceedings of IEEE International Conference on Communications,* May 2003, 2708-2711
- **JINGYU KANG ; PINGYI FAN ; ZHIGANG CAO.** Flexible construction of irregular partitioned permutation LDPC codes with low error floors. *IEEE Communications Letters,* June 2005, vol. 9 (6
- An introduction to LDPC codes. **W. E. RYAN.** CRC Handbook for Coding and Signal Processing for Recording Systems. CRC Press, 2004
- **S.-Y. CHUNG ; G. D. FORNEY ; T. J. RICHARDSON ; R. URBANKE.** On the design of low-density parity-check codes within 0.0045 dB of the Shannon limit. *IEEE Communications Letters,* February 2001, vol. 5 (2
- **A. RAMAMOORTHY ; R. WESEL.** Analysis of an algorithm for irregular LDPC code construction. *Proceedings of IEEE International Symposium on Information Theory,* 2004, 69
- **MARC P.C. FOSSORIER.** Quasi-cyclic low-density parity check codes from circulant permutation matrices. *IEEE Transactions On Information Theory,* August 2004, vol. 50 (8
- **RICH ECHARD ; SHIH-CHUN CHANG.** Design considerations leading to the development of good $\pi$-rotation LDPC codes. *IEEE Communications Letters,* May 2005, vol. 9 (5
- **R.M. TANNER ; DEEPAK SRIDHARA ; ARVIND SRIDHARAN ; THOMAS E. FUJA ; DANIEL J. COSTELLO.** LDPC block and convolutional codes based on circulant matrices. *IEEE Transactions on Information Theory,* December 2004, vol. 50 (12
- LDPC coding for OFDMA PHY. **B. CLASSON ; Y. BLANKENSHIP et al.** Tech. Rep. C802.16e-05/066r3. IEEE 802.16 Broadband Wireless Access Working Group, 2005